# EUROPEAN PATENT APPLICATION

(11) **EP 3 498 881 A2**
(43) Date of publication of application: **19.06.2019**
(21) Application number: 18185313.6
(22) Date of filing: 24.07.2018
(51) Int. Cl.: C23C 14/04, C23C 14/34, C23C 14/35, H01J 37/34

(54) **SPUTTER COATING DEVICE AND METHOD FOR SOLAR CELL**

(30) Priority: 14.12.2017 CN 201721752635 U
(71) Applicant: Miasolé Equipment Integration (Fujian) Co., Ltd., 362000 Quanzhou Fujian (CN)
(72) Inventor: ZHU, Pengjian, QUANZHOU, Fujian 362000 (CN); SUN, Hongxia, QUANZHOU, Fujian 362000 (CN); HU, Chao, QUANZHOU, Fujian 362000 (CN); SHU, Yi, QUANZHOU, Fujian 362000 (CN); PAN, Deng, QUANZHOU, Fujian 362000 (CN); CHEN, Fan, QUANZHOU, Fujian 362000 (CN); XU, Guojun, QUANZHOU, Fujian 362000 (CN)
(74) Representative: Cabinet Beau de Loménie

(57) **Abstract**

The present disclosure discloses a sputter coating device and method for a solar cell. The sputter coating device includes a target (1) for sputtering to a substrate (3), a blocking unit between the target (1) and the substrate (3), and the orthographic projection of the blocking unit on the substrate (3) partially coincides with the orthographic projection of the target (1) on the substrate (3). By providing a blocking unit between the target (1) and the substrate (3), a specific part of the target (1) may be blocked by the blocking unit, so that the thickness of the film layer formed by sputtering at the blocked part on the substrate (3) may be reduced, that is, by flexibly setting the position of the blocking unit, the thickness of the film layer formed by sputtering on the substrate (3) is consistent and the uniformity of the film layer is improved.

## Description

### TECHNICAL FIELD

The present disclosure relates to the art of solar cell processing, in particular to a sputter coating device and method for a solar cell.

### BACKGROUND

The flexible substrate copper indium gallium selenide (CIGS) thin film solar cell has the advantages of light weight, strong radiation resistance, and good stability. Combined with roll-to-roll technology, it is suitable for large-scale production and can significantly reduce material costs and manufacturing costs.

The window layer is not only the core part of the CIGS solar cell heterojunction n-type region, but also the main channel of the battery power output. The window layer is the film layer sputtered on the substrate, and the uniformity of the window layer is particularly important for the battery conversion efficiency and product yield. In the actual industrial production process, due to the characteristics of the target material, the distribution of the sputtering gas, and the distribution of the magnetic field in the target, the uniformity of the thickness of the prepared window layer is not ideal. By measuring the thickness of the window layer on the coated substrate, it may be seen that the middle part of the film layer is thicker, the upper and lower sides are thinner, and the uniformity is greatly deviated, which cannot meet the actual needs of industrial production.

### SUMMARY

The purpose of the present disclosure is to provide a sputter coating device and method for a solar cell to solve the problems in the related art and improve the uniformity of the film layer on the substrate.

According to one aspect of the present disclosure, a sputter coating device for a solar cell is used for sputtering a target to at least one substrate, wherein the sputter coating device for a solar cell comprises a blocking unit between the target and the substrate, and wherein the orthographic projection of the blocking unit on the substrate partially coincides with the orthographic projection of the target on the substrate.

According to an embodiment of the present disclosure, the orthographic projection of the blocking unit on the target is located in the middle of the target.

According to an embodiment of the present disclosure, the length of the blocking unit accounts for 50% to 75% of the length of the target.

According to an embodiment of the present disclosure, four targets are provided and arranged in-line, and the blocking unit is arranged at the target at the end in the arrangement direction.

According to an embodiment of the present disclosure, the sputter coating device for a solar cell further includes a fixing device for fixing the target.

According to an embodiment of the present disclosure, the fixing device is a target chamber, the target is fixed in the target chamber, an opening 40 is provided on the side of the target chamber near the substrate, and the blocking unit is fixed on the side of the target chamber where the opening 40 is provided.

According to an embodiment of the present disclosure, the blocking unit is detachably fixed on the target chamber and covers the middle of the opening.

According to an embodiment of the present disclosure, the target chamber is provided with an accommodating slot, and the target is fixed to the accommodating slot, and the opening communicates with the accommodating slot.

According to an embodiment of the present disclosure, the width of the blocking unit is equal to or greater than the width of the opening, and the length of the blocking unit accounts for 50%-75% of the length of the opening.

According to an embodiment of the present disclosure, the blocking unit is a baffle, and an anti-corrosion film layer is disposed on the baffle.

According to another aspect of the present disclosure, a sputter coating method for a solar cell is used for sputtering at least one target to a substrate, wherein the sputter coating method includes:

Providing a blocking unit between the target and the substrate, and wherein the orthographic projection of the blocking unit on the substrate partially coincides with the orthographic projection of the target on the substrate.

According to an embodiment of the present disclosure, the orthographic projection of the blocking unit on the target is located in the middle of the target.

According to an embodiment of the present disclosure, the length of the blocking unit accounts for 50% to 75% of the length of the target.

According to an embodiment of the present disclosure, four targets are provided and arranged in-line, and the blocking unit is arranged at the target at the end in the arrangement direction.

According to an embodiment of the present disclosure, the sputter coating method for a solar cell further includes providing a fixing device for fixing the target.

According to an embodiment of the present disclosure, the fixing device is a target chamber, the target is fixed in the target chamber, an opening is provided on the side of the target chamber near the substrate, and the blocking unit is fixed on the side of the target chamber where the opening is provided.

According to an embodiment of the present disclosure, the blocking unit is detachably fixed on the target chamber and covers the middle of the opening .

According to an embodiment of the present disclosure, the width of the blocking unit is equal to or greater than the width of the opening, and the length of the blocking unit accounts for 50%-75% of the length of the opening.

According to an embodiment of the present disclosure, the target chamber is provided with an accommodating slot, and the target is fixed to the accommodating slot, and the opening communicates with the accommodating slot.

According to an embodiment of the present disclosure, the blocking unit is a baffle, and an anti-corrosion film layer is disposed on the baffle.

In the sputter coating device and method for a solar cell provided by the present disclosure, by providing a blocking unit between the target and the substrate, a specific part of the target can be blocked by the blocking unit, so that the thickness of the film layer formed by sputtering at the blocked part on the substrate can be reduced, that is, by flexibly setting the position of the blocking unit, the thickness of the film layer formed by sputtering on the substrate is consistent and the uniformity of the film layer is improved, so as to meet the actual needs of industrial production.

### BRIEF DESCRIPTION OF THE DRAWINGS

FIG. 1 is a top view of a sputter coating device for a solar cell according to an embodiment of the present disclosure;
FIG. 2 is a front view of a sputter coating device for a solar cell according to another embodiment of the present disclosure.

### DETAILED DESCRIPTION

The embodiments of the present disclosure are described in detail below, and examples of the embodiments are shown in the accompanying drawings, wherein the same or similar reference numerals denote the same or similar elements or elements having the same or similar functions throughout. The embodiments described below with reference to the drawings are exemplary, are used to explain the present disclosure only, and not intended to limit the present disclosure.

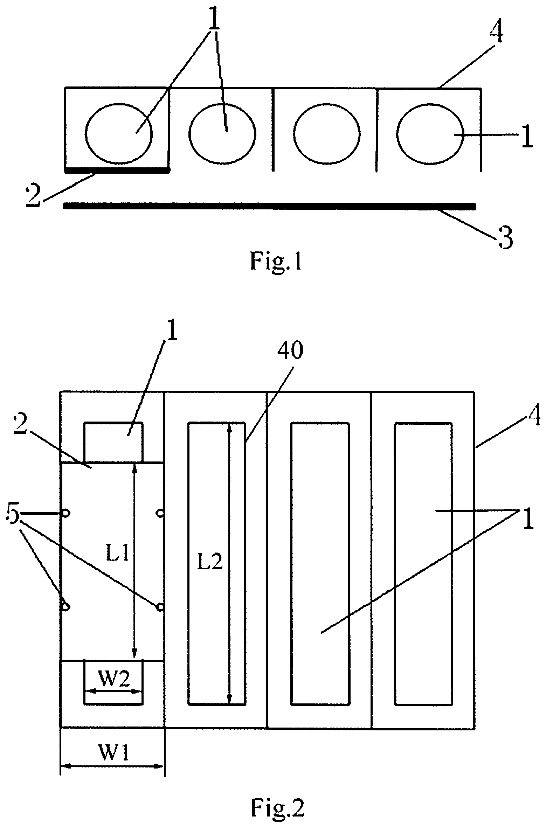

As shown in FIG. 1, also referring to FIG. 2, an embodiment of the present disclosure provides a sputter coating device for a solar cell is used for sputtering a target to a substrate, wherein the sputter coating device for a solar cell includes a blocking unit 2.

The blocking unit 2 is located between the target 1 and the substrate 3, and the orthographic projection of the blocking unit 2 on the substrate 3 partially coincides with the orthographic projection of the target 1 on the substrate 3.

In the sputter coating device for a solar cell provided by the present disclosure, by providing a blocking unit 2 between the target 1 and the substrate 3, a specific part of the target 1 may be blocked by the blocking unit 2, so that the thickness of the film layer formed by sputtering at the blocked part on the substrate 3 may be reduced, that is, the part of the target 1 corresponding to the thicker part of the film layer previously formed on the substrate 3 is blocked by the blocking unit 2, so that the thickness of the film layer formed on the substrate 3 by sputtering the blocked part and the non-blocking part tends to be uniform.

In the sputter coating device for a solar cell provided by the present disclosure, by flexibly setting the position of the blocking unit 2, the thickness of the film layer formed by sputtering on the substrate 3 is consistent and the uniformity of the film layer is improved, so as to meet the actual needs of industrial production.

In an embodiment, the blocking unit 2 is fixed with respect to the target 1, and the orthographic projection of the blocking unit 2 on the target 1 is located in the middle of the target 1. In an embodiment, the blocking unit 2 is disposed close to the target 1, and faces the middle of the target 1. In an embodiment, the length of the blocking unit 2 accounts for 50% to 75% of the length of the target 1.

Wherein, in the embodiment of the present disclosure, the blocking unit 2 is disposed close to the target 1, and it may also not be disposed close to the target 1, but only the projection is located in the middle of the target 1 so as to block the middle of the target 1. Generally, the length of the blocking unit 2 accounts for 70% of the length of the target 1, i.e., 15% at both ends are not blocked, so that the middle part (where the thickness was previously thicker) of the film layer formed on the substrate 3 may be heavily blocked, so that the thickness of the film layer at the part is reduced, and the overall thickness of the film layer is uniform. The shapes of the target 1 and the blocking unit 2 are not limited, as long as the blocking unit 2 may partially block.

Optionally, the blocking unit 2 may also be disposed close to the substrate 3, and the blocking unit 2 faces the middle part of the substrate 3. In an embodiment, the length of the blocking unit 2 accounts for 50%-75% of the length of the substrate 3. In the same way, in the embodiment of the present disclosure, the blocking unit 2 may also be disposed close to the substrate 3, and the purpose of making the overall thickness of the film layer uniform may also be achieved.

In the embodiment of the present disclosure, in an embodiment, four targets 1 are provided and arranged in-line, and the blocking unit 2 is arranged at the target 1 at the end in the arrangement direction. In an embodiment, four targets 1 are sequentially arranged in parallel, and the blocking unit 2 is arranged at the fourth target 1 or the first target 1. Blocking one of the four targets 1 may generally make the thickness of the sputtered film layer uniform. Obviously, those skilled in the art understand that the number of targets 1, the number of blocked targets 1, and the number of blocking units 2 are not limited, and may be flexibly set according to actual conditions.

In an embodiment, the sputter coating device for a solar cell further includes a fixing device for fixing the target 1, the fixing device, for example, is a target chamber . In an embodiment, an accommodating slot for accommodating the target 1 is provided in the target chamber 4, and the side of the target chamber near the substrate 3 is provided with an opening 40 communicating with the accommodating slot. The target 1 is sputtered to the substrate 3 through the opening 40. In an embodiment, the blocking unit 2 is fixed on the side of the target chamber 4 where the opening 40 is provided, and the blocking unit 2 covers the middle of the opening 40. In an embodiment, the blocking unit 2 is detachably fixed to the target chamber 4 by a detachable connecter such as a screw 5. In an embodiment, the width of the blocking unit 2 is equal to or greater than the width of the opening 40, and the length of the blocking unit 2 accounts for 50%-75%, such as 55%, 60%, 65%, and 70% of the length of the opening 40.

Wherein, the target 1 has a variety of shapes, such as a cylindrical shape or a cuboid shape, or the like, and correspondingly, an accommodating slot having the same shape is provided in the target chamber 4, into which the target 1 may be directly inserted. In order to reserve a channel for direct sputtering of the target 1 to the substrate 3, an opening 40 is formed on the target chamber 4, and the opening 40 is generally located between the target 1 and the substrate 3. The width of the opening 40 is less than or equal to the width of the target 1 to prevent the target 1 from leaking out of the opening 40, and the width of the blocking unit 2 is greater than or equal to the width of the opening 40, so as to ensure complete blocking of a specific part of the target 1. Corresponding position on the target chamber 4 is provided with a pin hole, which may cooperate with the screw 5 to fix the blocking unit 2.

In an embodiment, the blocking unit 2 is a baffle, and an anti-corrosion film layer is disposed on the baffle.

Wherein, the baffle is 304 austenitic stainless steel, which has extremely strong rust and corrosion resistance, but also excellent plasticity and toughness, and is easy to manufacture. The size and the shielding position of the baffle may be changed according to actual needs so as to achieve a uniform coating of a large area on the substrate 3. The anti-corrosion layer is generally made of titanium.

The sputter coating method for a solar cell according to the present disclosure is used for sputtering a target 1 to a substrate 3, wherein the sputter coating method includes:

Providing a blocking unit 2 between the target 1 and the substrate 3, and the orthographic projection of the blocking unit 2 on the substrate 3 partially coincides with the orthographic projection of the target 1 on the substrate 3. The orthographic projection of the blocking unit 2 on the target 1 is located in the middle of the target 1. The length of the blocking unit 2 accounts for 50% to 75% of the length of the target. In an embodiment, the blocking unit 2 is a baffle, and an anti-corrosion film layer is disposed on the baffle.

In an embodiment, the sputter coating method for a solar cell further includes providing a fixing device for fixing the target 1.

In an embodiment, the fixing device is a target chamber 4, an opening 40 is provided on the side of the target chamber 4 near the substrate 3, and the blocking unit 2 is fixed on the side of the target chamber 4 where the opening 40 is provided. The target chamber 4 is provided with an accommodating slot, the target 1 is fixed to the accommodating slot, and the opening 40 communicates with the accommodating slot.

The blocking unit 2 is detachably fixed to the target chamber 4, for example, it is detachably fixed to the target chamber 4 by a screw 5. The blocking unit 2 covers the middle of the opening 40.

The width W1 of the blocking unit 2 is equal to or greater than the width W2 of the opening 40, and the length L1 of the blocking unit 2 accounts for 50%-75%, such as 55%, 60%, 65%, and 70% of the length L2 of the opening 40.

In an embodiment, four targets 1 are provided and arranged in-line, and the blocking unit 2 is arranged at the target 1 at the end in the arrangement direction.

In the embodiment of the present disclosure, the conditions before and after disposing the blocking unit 2 are respectively tested, and the specific results are as follows:

**Table 1. Test results before disposing the blocking unit**

| Measuring position (cm) | | Thickness of the window film before improvement (nm) |
|---|---|---|
| Upper | 7.5 | 408.5 |
| | 15 | 421.4 |
| Middle | 29 | 444.9 |
| | 43 | 446.6 |
| | 57 | 445.4 |
| | 71 | 441.5 |
| Lower | 85 | 416 |
| | 92.5 | 405.6 |
| Uniformity | | 90.44% |

**Table 2. Test results after disposing the blocking unit**

| Measuring position (cm) | | Thickness of the window film after improvement (nm) |
|---|---|---|
| Upper | 7.5 | 419.9 |
| | 15 | 424.9 |
| Middle | 29 | 429.7 |
| | 43 | 433.1 |
| | 57 | 432.9 |
| | 71 | 428.3 |
| Lower | 85 | 422.4 |
| | 92.5 | 417.5 |
| Uniformity | | 96.34% |

Through research, it has been found that the present disclosure may significantly improve the uniformity of the film layer on the substrate 3, and its uniformity increases from 90.44% to 96.34%, which may meet the actual needs of industrial production.

The structures, features, and effects of the present disclosure are described in detail based on the embodiments shown in the drawings. The above description is only the preferred embodiments of the present disclosure, but the present disclosure does not limit the scope of implementation as shown in the drawings. Any changes made according to the concept of the present disclosure, or equivalent embodiments that are modified to equivalent changes, should still fall within the protection scope of the present disclosure if they do not go beyond the spirit covered by the description and the drawings.

## Claims

1. A sputter coating device for a solar cell used for sputtering at least one target (1) to a substrate (3) comprising:
a blocking unit (2) between said at least one target (1) and the substrate (3), wherein an orthographic projection of the blocking unit (2)on the substrate (3) partially coincides with an orthographic projection of said at least one target (1) on the substrate (3).

2. The sputter coating device for a solar cell according to claim 1, wherein the orthographic projection of the blocking unit (2) on the said at least one target (1) is located in the middle of the target (1).

3. The sputter coating device for a solar cell according to claim 2, wherein the length of the blocking unit (2) accounts for 50% to 75% of the length of the target (1).

4. The sputter coating device for solar cells according to claim 1, wherein four targets (1) are provided and arranged in-line, and the blocking unit (2) is arranged at the target (1) at the end in the arrangement direction.

5. The sputter coating device for a solar cell according to claim 1, further comprising a fixing device configured to fix the at least one target.

6. The sputter coating device for a solar cell according to claim 5, wherein the fixing device is a target chamber (4), the at least one target (1) being fixed in the target chamber (4), an opening (40) being provided on a side of the target chamber (4) near the substrate (3), and the blocking unit (2) being fixed on the side of the target chamber (4)where the opening (40) is provided.

7. The sputter coating device for a solar cell according to claim 6, wherein the blocking unit (2) is detachably fixed on the target chamber (4) and covers the middle of the opening (40).

8. The sputter coating device for a solar cell according to claim 5, wherein an accommodating slot is provided in the target chamber (4), the target (1) being fixed to the accommodating slot, and the opening (40) communicates with the accommodating slot.

9. The sputter coating device for a solar cell according to claim 8, wherein the width of the blocking unit (2) is equal to or greater than the width of the opening (40), and the length of the blocking unit (2) accounts for 50%-75% of the length of the opening (40).

10. The sputter coating device for a solar cell according to anyone of claims 1 to 9, wherein the blocking unit (2) is a baffle, and an anti-corrosion film layer is disposed on the baffle.

11. A sputter coating method for a solar cell used for sputtering at least one target (1) to a substrate (3), wherein the sputter coating method comprises:
providing a blocking unit (2) between the at least one target (1) and the substrate (3), and
wherein an orthographic projection of the blocking unit (2) on the substrate (3) partially coincides with an orthographic projection of said at least one target (1) on the substrate (3).

12. The sputter coating method for a solar cell according to claim 11, wherein the orthographic projection of the blocking unit (2) on the at least one target (1) is located in the middle of said at least one target (1).

13. The sputter coating method for a solar cell according to claim 11, wherein the length of the blocking unit (2) accounts for 50% to 75% of the length of the at least one target (1).

14. The sputter coating method for a solar cell according to claim 11, wherein four targets (1) are provided and arranged in-line, and the blocking unit (2) is arranged at the target (1) at the end in the arrangement direction.

15. The sputter coating method for a solar cell according to claim 11, further comprises:
providing a fixing device for fixing the target (1).
